# EUROPÄISCHE PATENTSCHRIFT

(11) **EP 3 791 394 B1**
(45) Veröffentlichungstag und Bekanntmachung des Hinweises auf die Patenterteilung: **06.07.2022**
(21) Anmeldenummer: 19722076.7
(22) Anmeldetag: 02.05.2019
(51) Int. Cl.: G11C 7/10

(54) **STATISCHER DIREKTZUGRIFFSSPEICHER-BLOCK MIT EINGANGSDATENADDIERER SOWIE EMPFANGSSENSOR**
STATIC DIRECT ACCESS MEMORY BLOCK HAVING AN INPUT DATA ADDER AND RECEIVING SENSOR
BLOC STATIQUE DE MÉMOIRE VIVE COMPRENANT UN ADDITIONNEUR DE DONNÉES D'ENTRÉE ET CAPTEUR DE RÉCEPTION

(30) Priorität: 07.05.2018 DE 102018207020
(43) Veröffentlichungstag der Anmeldung: 17.03.2021
(73) Patentinhaber: Robert Bosch GmbH, 70442 Stuttgart (DE)
(72) Erfinder: SCHMAUKE, Mathias, 72149 Neustetten (DE); FIBRANZ, Heiko, 72770 Reutlingen (DE)
(86) Internationale Anmeldenummer: PCT/EP2019/061213
(87) Internationale Veröffentlichungsnummer: WO 2019/215002

(56) Entgegenhaltungen:
- WO-A1-2017/201050
- DE-A1- 4 137 515
- US-A1- 2002 188 798
- US-A1- 2009 228 538

## Beschreibung

Die vorliegende Erfindung betrifft einen statischen Direktzugriffsspeicher-Block insbesondere für einen Empfangssensor, umfassend ein Speicherzellenfeld, einen Zeilenadressen-Dekodierer, einen Spaltendaten-Multiplexer, ein Lese- und Schreibmodul mit einem Leseverstärker und einem Schreib-Treiber, eine Steuerlogik, einen Dateneingang und einen Datenausgang, wobei der statische Direktzugriffsspeicher-Block eine interne Speichertaktung aufweist. Die Erfindung betrifft außerdem einen Empfangssensor umfassend mindestens einen derartigen statischen Direktzugriffsspeicher-Block.

### Stand der Technik

In Lidar- und Radar-Sensor-ASIC (application-specific integrated circuits = anwendungsspezifische integrierte Schaltungen) müssen sehr schnell sehr viele Daten vom Empfangssensor verarbeitet und gespeichert werden. Da viele Daten parallel anfallen, werden die Eingangsdaten in vielen kleinen Direktzugriffsspeicher-Blöcken abgelegt. Dazu werden bis zu zum Beispiel 2000 SRAM (static random-access memory = statische Direktzugriffsspeicher) - Blöcke der Größe von 500 Datenwörtern mit je 128 Bit auf dem ASIC integriert. Um die Daten vom Empfangssensor zu verarbeiten, müssen zum Beispiel bei einer Frequenz von 500 MHz die Daten aus den SRAM ausgelesen, verarbeitet und wieder zurückgeschrieben werden. Das Auslesen und die Verarbeitung erfolgt jeweils in einem Speichertakt, das Zurückschreiben im folgenden Speichertakt.

Bei der Datenverarbeitung handelt es sich zum Beispiel darum, aus den Eingangsdaten auf einen im SRAM-Block stehenden 8 Bit-Wert einen 6 Bit-Wert aufzuaddieren. Der resultierende 8-bit-Wert wird im nächsten Takt wieder an gleiche Position im SRAM-Block zurückgeschrieben. Um nicht zu viele einzelne SRAM-Blöcke zu erhalten, werden zum Beispiel immer 16 Werte zu einer Einheit Eingangsdaten für jeden SRAM-Block zusammengefasst, sodass sich eine Wortbreite von 16 * 8 Bit = 128 Bit ergibt. In Lidar-Systemen fallen trotzdem noch so viele Daten parallel an, dass 8 SRAM-Blöcke parallel angesprochen werden müssen.

Neben dem hohen Flächenbedarf der SRAM-Blöcke auf dem ASIC ist ein Hauptproblem der hohe Stromverbrauch und damit die hohe abzuführende Wärme, da über lange Zeiträume alle 8 SRAM-Blöcke parallel in jedem Takt gelesen oder geschrieben werden.

Werden auf einem ASIC SRAM-Blöcke eingebaut, so ist es Standard, dass der Halbleiter-Prozess-Entwickler auch einen Generator zur Verfügung stellt, der RAM-IP (statischer Direktzugriffspeicherblock) generiert, bestehend aus einem Schaltplan und einem Layout sowie weiteren Dateien, um den Block ins Design einbinden zu können. Diese Standard-SRAM-Blöcke umfassen ein Speicherzellenfeld, einen Zeilenadressen-Dekodierer, einen Spaltendaten-Multiplexer, ein Lese- und Schreibmodul mit einem Leseverstärker und einem Schreib-Treiber, eine Steuerlogik, einen Dateneingang und einen Datenausgang.

Der Spaltendaten-Multiplexer ist notwendig, da in der Regel in einer Zeile des Speicherzellenfelds mehrere Datenwörter gespeichert sind und der Spaltendaten-Multiplexer wählt das selektierte Datenwort aus. Übliche Multiplexfaktoren bei SRAM-Blöcken sind je nach Größe 4, 8 oder 16. Es werden mehrere Datenwörter pro Zeile platziert, um einen flächenoptimalen SRAM-Block zu erhalten.

Wird auf einen SRAM-Block zugegriffen, so werden die Daten innerhalb eines Taktes gelesen oder geschrieben. Im SRAM-Block werden aber mehrere Zustände durchlaufen. Der Ablauf wird durch die steigende Flanke des Speichertakts angestoßen, der Übergang in den nächsten Zustand erfolgt aber über Verzögerungs-Glieder zum Beispiel eines Kopierpfades mit der längsten Verzögerung im Vergleich zu den Nutzdaten.

Das Dokument DE 41 37 515 A1 offenbart eine integrierte Halbleiterschaltungsvorrichtung mit darin integriertem Speicher und Operationseinheit.

### Offenbarung der Erfindung

Erfindungsgemäß wird ein statischer Direktzugriffsspeicher-Block der eingangs genannten Art bereitgestellt, dadurch gekennzeichnet, dass in den statischen Direktzugriffsspeicher-Block mindestens ein Addierer zum Addieren von durch den Dateneingang eingegangenen Eingangsdaten integriert ist, wobei der mindestens eine Addierer zwischen dem Dateneingang und dem Lese- und Schreibmodul angeordnet ist.

### Vorteile der Erfindung

Dadurch, dass mindestens ein Addierer in den statischen Direktzugriffsspeicher-Block integriert ist, können die Eingangsdaten effizienter verarbeitet werden und Lese- und Schreibvorgänge zusammengefasst werden. Das Resultat ist eine Einsparung im Stromverbrauch und in der Wärmeerzeugung der statischen Direktzugriffsspeicher-Blöcke.

Vorteilhafte Weiterbildungen der Erfindung sind in den Unteransprüchen angegeben und in der Beschreibung beschrieben.

In einer Ausführungsform ist der statische Direktzugriffsspeicher-Block dazu eingerichtet, in einem Speichertakt ein ursprüngliches Datenwort aus dem Speicherzellenfeld auszulesen, den mindestens einen Addierer die Addition der Eingangsdaten durchführen zu lassen und dann ein resultierendes Datenwort in das Speicherzellenfeld zurückzuschreiben. Es werden also in einem Speichertakt die Daten aus dem Speicherzellenfeld ausgelesen, die Addition durchgeführt und wieder in das Speicherzellenfeld zurückgeschrieben. Daraus ergeben sich folgende Vorteile:
- Pro Datenverarbeitungsschritt wird das Speicherzellenfeld nur einmal angesprochen, anstatt zweimal.
- Da sich die Zugriffe auf das Speicherzellenfeld und den SRAM-Block insgesamt halbieren, kann dieser mit dem halben Speichertakt (zum Beispiel 250 MHz statt 500 MHz) betrieben werden.
- Beim Zurückschreiben des resultierenden Datenworts ist die entsprechende Speicherzeile bereits geöffnet und hat den definierten Pegel der alten Daten (des ursprünglichen Datenworts). Für den Schreibvorgang werden vorzugsweise nur die Bits umprogrammiert, deren Inhalt sich ändert.

Alle drei Punkte führen, insbesondere zusammen, zur Reduktion der verbrauchten Energie, insbesondere da eine Reduktion des notwendigen Speichertaktes bei der gleichen verarbeiteten Menge an Eingangsdaten ermöglicht wird.

In einer Ausführungsform ist der statische Direktzugriffsspeicher-Block so eingerichtet, dass in einem Speichertakt nur ein Vorladen einer Speicherzeile, eine Adressen-Decodierung mit Öffnen der Speicherzeile und Auswahl des ursprünglichen Datenworts und ein Schließen der Speicherzeile erfolgt. Diese Ausführungsform reduziert die verbrauchte Energie noch weiter, da weniger Vorlade-Vorgänge notwendig sind, um dieselbe Menge an Eingangsdaten zu verarbeiten. Die Speicherzeile muss also kein zweites Mal geöffnet werden in einem folgenden Speichertakt, sondern sie ist noch offen, wenn das resultierende Datenwort in die Speicherzeile zurückgeschrieben wird.

In einer Ausführungsform ist der statische Direktzugriffsspeicher-Block so eingerichtet, dass beim Zurückschreiben des resultierenden Datenworts die Speicherzeile bereits geöffnet ist und den definierten Pegel des ursprünglichen Datenworts aufweist, und wobei beim Zurückschreiben nur die Datenbits umgeladen werden, deren Inhalt sich zwischen dem ursprünglichen Datenwort und dem resultierenden Datenwort geändert hat. Somit werden unnötige Umladevorgänge vermieden und weiter Energie eingespart. Dies wird dadurch ermöglicht, dass das Zurückschreiben des resultierenden Datenworts im selben Speichertakt wie das Auslesen des ursprünglichen Speicherworts erfolgt.

In einer bevorzugten Ausführungsform ist der mindestens eine Addierer so eingerichtet, dass er die Eingangsdaten auf Datenpakete prüft, die null sind, wobei in dem aktuellen Speichertakt nur solche Datenpakete aus dem ausgewählten ursprünglichen Datenwort im Speicherzellenfeld ausgelesen werden, mit Eingangsdaten addiert werden und zurückgeschrieben werden, die solchen Datenpaketen aus den Eingangsdaten entsprechen, die ungleich null sind. In dieser Ausführungsform sind die Addierer also so eingerichtet, dass sie eine Vorsortierung der Eingangsdaten vornehmen. Werden Datenpakete in den Eingangsdaten entdeckt, deren Bits komplett Null sind (also beispielsweise alle 6 Bits eines Datenpakets), so wird für diese Datenpakete keine Datenverarbeitung ausgeführt und die entsprechenden Datenpakete aus dem Speicherzellenfeld werden weder ausgelesen, noch addiert oder später zurückgeschrieben. Dadurch lassen sich unnötige Lese- und Schreibvorgänge vermeiden und der Energieverbrauch lässt sich weiter senken.

In einer weiteren Ausführungsform umfasst der statische Direktzugriffsspeicher-Block ein zweites Lese- und Schreibmodul, das zwischen dem Speicherzellenfeld und dem Datenausgang angeordnet ist, und wobei der Spaltendaten-Multiplexer einen Multiplexfaktor von 1 aufweist, sodass alle Zellen einer Zeile des Speicherzellenfelds in einem Speichertakt ausgelesen werden, und nach der Verarbeitung der Eingangsdaten das resultierende Datenwort in dieselbe Zeile zurückgeschrieben wird. Diese Ausführungsform hat den Vorteil, dass wenn mehrere derartige statische Direktzugriffsspeicher-Blöcke zusammen in einer anwendungsspezifischen integrierten Schaltung verwendet werden, anstatt eines Aufteilens eines Datenpakets (zum Beispiel von Sensordaten) in eine Vielzahl von Eingangsdaten(-Paketen) für verschiedene statische Direktzugriffsspeicher-Blöcke alle Eingangsdaten an nur einen statischen Direktzugriffsspeicher-Block oder zumindest an deutliche weniger statische Direktzugriffsspeicher-Blöcke gesendet werden können. Der oder die aktiven statische(n) Direktzugriffsspeicher-Block/Blöcke können dann in einem Speichertakt vollständig ausgelesen und überschrieben werden. Im nächsten Speichertakt können dann die zu verarbeitenden Daten an andere statische(n) Direktzugriffsspeicher-Block/Blöcke gesendet werden und die statische(n) Direktzugriffsspeicher-Block/Blöcke, die im vorherigen Speichertakt aktiv waren, werden nicht verwendet. Auch durch diese Vorgehensweise lässt sich gegenüber dem Stand der Technik Energie einsparen.

In einer bevorzugten Ausführungsform umfasst der statische Direktzugriffsspeicher-Block mindestens 16 Addierer, wobei jeder Addierer dazu eingerichtet ist, pro Speichertakt 6 Bit Daten der Eingangsdaten zu verarbeiten und diese 6 Bit Daten zu 8 Bit Daten des ursprünglichen Datenworts zu addieren. Für einen solchen statischen Direktzugriffsspeicher-Block ist die erfindungsgemäße Lösung besonders geeignet, da die hohe Anzahl an Addierern eine effektive Reduzierung des Energieverbrauchs erlaubt.

Erfindungsgemäß wird außerdem ein Empfangssensor, insbesondere für ein Radar-oder Lidar-System, bereitgestellt, umfassend eine anwendungsspezifische integrierte Schaltung, wobei die anwendungsspezifische integrierte Schaltung mindestens einen statischen Direktzugriffsspeicher-Block nach einer der vorstehenden Ausführungsformen umfasst. Der erfindungsgemäße statische Direktzugriffsspeicher-Block kann besonders in Radar-oder Lidar-Systemen, die häufig SRAM-Blöcke verwenden, eine deutliche Reduktion des Energieverbrauchs erreichen.

In einer Ausführungsform umfasst der Empfangssensor mindestens zwei statische Direktzugriffsspeicher-Blöcke, wobei in jedem Speichertakt nur ein statischer Direktzugriffsspeicher-Block mit Eingangsdaten angesprochen wird. Diese Ausführungsform hat den Vorteil, dass anstatt eines Aufteilens der Sensordaten in eine Vielzahl von Eingangsdaten(-Paketen) für verschiedene statische Direktzugriffsspeicher-Blöcke alle Eingangsdaten an nur einen statischen Direktzugriffsspeicher-Block oder zumindest an deutlich weniger statische Direktzugriffsspeicher-Blöcke gesendet werden können. Der oder die aktiven statische(n) Direktzugriffsspeicher-Block/Blöcke können dann in einem Speichertakt vollständig ausgelesen und überschrieben werden. Im nächsten Speichertakt können dann die zu verarbeitenden Sensordaten an andere statische(n) Direktzugriffsspeicher-Block/Blöcke gesendet werden und die statische(n) Direktzugriffsspeicher-Block/Blöcke, die im vorherigen Speichertakt aktiv waren, werden nicht verwendet. Auch durch diese Vorgehensweise lässt sich gegenüber dem Stand der Technik Energie einsparen.

### Zeichnungen

Ausführungsbeispiele der Erfindung werden anhand der Zeichnungen und der nachfolgenden Beschreibung näher erläutert. Es zeigen:
Figur 1 einen statischen Direktzugriffsspeicher-Block des Standes der Technik,
Figur 2 eine erste Ausführungsform eines erfindungsgemäßen statischen Direktzugriffsspeicher-Blocks,
Figur 3 eine zweite Ausführungsform eines erfindungsgemäßen statischen Direktzugriffsspeicher-Blocks, und
Figur 4 eine dritte Ausführungsform eines erfindungsgemäßen statischen Direktzugriffsspeicher-Blocks.

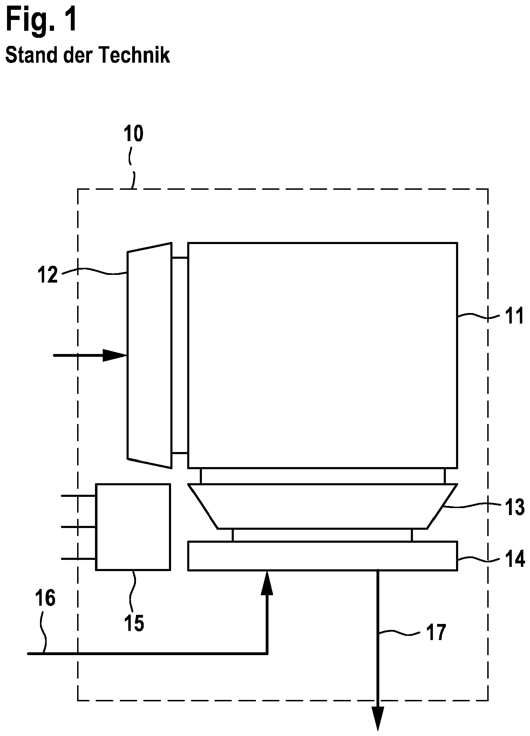

Figur 1 zeigt einen statischen Direktzugriffsspeicher-Block 10 des Standes der Technik. Der statische Direktzugriffsspeicher-Block (SRAM-Block) 10 umfasst ein Speicherzellenfeld 11, einen Zeilenadressen-Dekodierer 12, einen Spaltendaten-Multiplexer 13, ein Lese- und Schreibmodul 14 umfassend einen Leseverstärker und einen Schreib-Treiber, eine Steuerlogik 15, einen Dateneingang 16 und einen Datenausgang 17. Datenverarbeitung wie beispielsweise das Addieren von Sensordaten erfolgt im Stand der Technik außerhalb des SRAM-Blocks 10. In einem Speichertakt wird dazu ein ursprüngliches Datenwort ausgewählt, die Speicherzeile vorgeladen und ausgelesen und an den Datenausgang 16 gesendet. Die Speicherzeile wird wieder geschlossen. Im folgenden Speichertakt werden die verarbeiteten Daten dann über den Dateneingang 16 zurückgeführt, die vorherige Speicherzeile erneut vorgeladen, geöffnet und das resultierende Datenwort in das Speicherzellenfeld 11 zurückgeschrieben.

### Ausführungsformen der Erfindung

Ziel dieser Erfindung ist es, den Stromverbrauch der SRAM-Blöcke zu senken. Dazu werden drei Optimierungen verfolgt:
1. Zusammenfassung des Lese-, Verarbeitungs- und Schreibvorgangs.
2. Nur sich ändernde Daten werden im SRAM-Block verarbeitet.
3. Eine komplette Speicherzeile des Speicherzellenfelds wird bearbeitet.

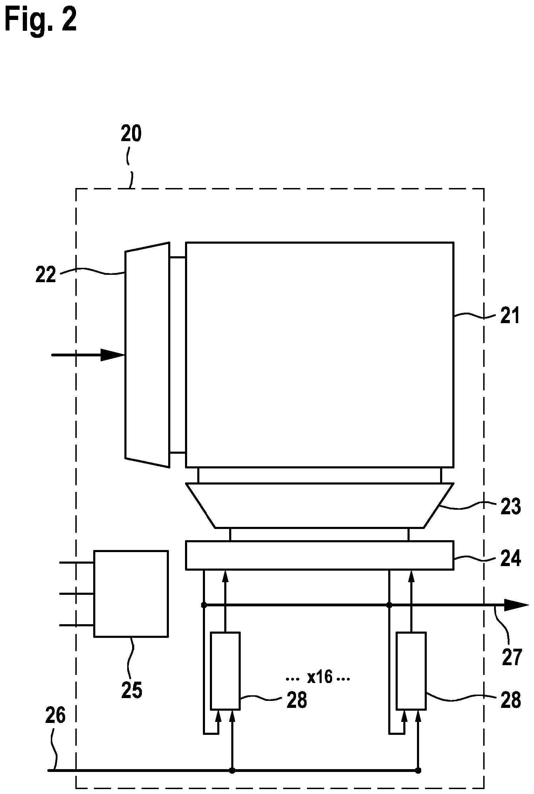

Figuren 2, 3 und 4 zeigen beispielhafte Ausführungsformen der Erfindung, die jeweils mindestens eine dieser Optimierungen verwenden.

In den Figuren 2 bis 4 tragen entsprechende Merkmale die gleichen Bezugszeichen.

In der Figur 2 ist eine erste Ausführungsform eines erfindungsgemäßen statischen Direktzugriffsspeicher-Blocks 20 dargestellt. Der statische Direktzugriffsspeicher-Block 20 umfasst ein Speicherzellenfeld 21, einen Zeilenadressen-Dekodierer 22, einen Spaltendaten-Multiplexer 23, ein Lese- und Schreibmodul 24 umfassend einen Leseverstärker und einen Schreib-Treiber, eine Steuerlogik 25, einen Dateneingang 26 und einen Datenausgang 27. Zusätzlich umfasst der statische Direktzugriffsspeicher-Block 20 mindestens einen Addierer 28 zum Addieren von durch den Dateneingang 26 eingegangenen Eingangsdaten, wobei der mindestens eine Addierer 28 zwischen dem Dateneingang 26 und dem Lese- und Schreibmodul 24 angeordnet ist.

In den vorliegenden Ausführungsformen der Figuren 2 bis 4 umfasst der statische Direktzugriffsspeicher-Block 20 jeweils 16 Addierer 28. Jeder Addierer 28 kann zum Beispiel dazu eingerichtet sein, pro Speichertakt 6-Bit Daten der Eingangsdaten zu verarbeiten und diese 6-Bit Daten zu 8-Bit Daten des ursprünglichen Datenworts zu addieren. Es sind aber auch andere Speicherkonfigurationen, andere Datenpaketgrößen (als 6-Bit oder 8-Bit) und/oder andere Mengen an Addierern 28 verwendbar, um die Erfindung auszuführen.

Dadurch, dass Addierer 28 in den statischen Direktzugriffsspeicher-Block 20 integriert sind, können die Eingangsdaten effizienter verarbeitet werden und die Anzahl der unnötigen Lese- und Schreibvorgänge verringert werden. Daraus resultiert eine Einsparung im Energieverbrauch und in der Wärmeerzeugung der statischen Direktzugriffsspeicher-Blöcke 20.

In der Ausführungsform der Figur 2 ist der statische Direktzugriffsspeicher-Block 20 dazu eingerichtet, in einem Speichertakt ein ursprüngliches Datenwort aus dem Speicherzellenfeld auszulesen, die Addierer 28 die Addition der Eingangsdaten durchführen zu lassen und dann ein resultierendes Datenwort in das Speicherzellenfeld 21 zurückzuschreiben. Es werden also in einem Speichertakt die Daten aus dem Speicherzellenfeld 21 ausgelesen, die Addition durchgeführt und das resultierende Datenwort wieder in das Speicherzellenfeld 21 zurückgeschrieben. Daraus ergeben sich folgende Vorteile:
- Pro Datenverarbeitungsschritt wird das Speicherzellenfeld 21 nur einmal angesprochen, anstatt zweimal.
- Da sich die Zugriffe auf das Speicherzellenfeld 21 und den SRAM-Block 20 insgesamt halbieren, kann dieses mit dem halben Speichertakt (zum Beispiel 250 MHz statt 500 MHz) betrieben werden.
- Beim Zurückschreiben des resultierenden Datenworts ist die entsprechende Speicherzeile im Speicherzellenfeld 21 bereits geöffnet (da wir uns noch in demselben Speichertakt befinden) und hat den definierten Pegel der alten Daten (des ursprünglichen Datenworts). Für den Schreibvorgang werden vorzugsweise nur die Bits überschrieben, deren Inhalt sich ändert.

Alle drei Punkte führen, insbesondere zusammen, zur Reduktion der verbrauchten Energie, insbesondere da eine Reduktion des notwendigen Speichertaktes bei der gleichen verarbeiteten Menge an Eingangsdaten ermöglicht wird.

In Figur 2 ist zu erkennen, dass die Addierer 28 direkt in den SRAM-Block 20 integriert werden. Nach dem Lesen der alten Daten werden die Leseverstärker des Lese- und Schreibmoduls 24 von den Speicherzeilen getrennt, die Eingangsdaten zu den gelesenen Daten (zum ursprünglichen Datenwort) dazu addiert und in das Speicherzellenfeld 21 zurückgeschrieben (Read-Modify-Write-Cycle).

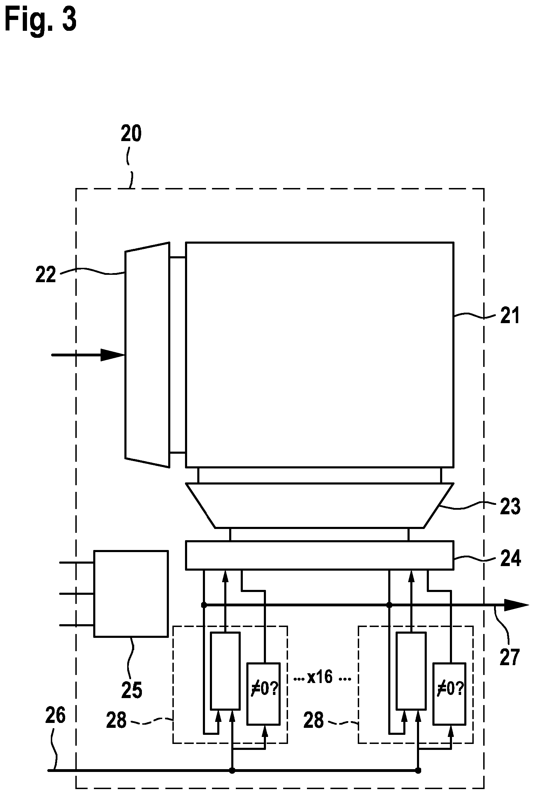

In der Figur 3 ist eine zweite Ausführungsform eines erfindungsgemäßen statischen Direktzugriffsspeicher-Blocks 20 dargestellt. Auch hier sind Addierer 28 in den Direktzugriffsspeicher-Block 20 integriert.

In einem Datenwort des SRAM-Blocks 10 der Figur 1 werden zum Beispiel 16 aufkumulierte Werte je 8-Bit gespeichert. Die Wahrscheinlichkeit, dass ein Teil der neuen Eingangsdaten den Wert null hat, ist systembedingt relativ hoch. Ist ein Eingangsdatum null, braucht man es nicht zu dem gespeicherten Wert hinzuaddieren, da es sich nicht ändert. Stattdessen könnte man den ursprünglichen Wert von vornherein nicht auszulesen, addieren und zurückzuschreiben. Da man aber immer mehrere (zum Beispiel 16) Werte in einem SRAM-Datenwort parallel speichert, muss man im Stand der Technik doch das gesamte Datenwort auslesen, da die Wahrscheinlichkeit sehr gering ist, dass alle 16 Eingangsdaten-Werte null sind.

Werden die Addierer 28 aber wie erfindungsgemäß in Figur 3 in den SRAM-Block 20 integriert, kann man die Eingangsdaten prüfen und die entsprechenden Bits im Datenwort nur auslesen und bearbeiten, wenn diese ungleich null sind.

Dies wird durch die Addierer 28 in dieser Ausführungsform ausgeführt. Dadurch kann man den Stromverbrauch um den Teil verringern, den es kostet, den ursprünglichen Datenwert auszulesen und zurückzuschreiben (der sich durch die Verarbeitung nicht verändert hätte).

Die Addierer 28 sind also so eingerichtet, dass sie die Eingangsdaten auf Bits prüfen, die null sind, wobei in dem aktuellen Speichertakt nur solche Bits aus dem ausgewählten ursprünglichen Datenwort im Speicherzellenfeld 21 ausgelesen, mit Eingangsdaten addiert und zurückgeschrieben werden, die solchen Bits aus den Eingangsdaten entsprechen, die ungleich null sind.

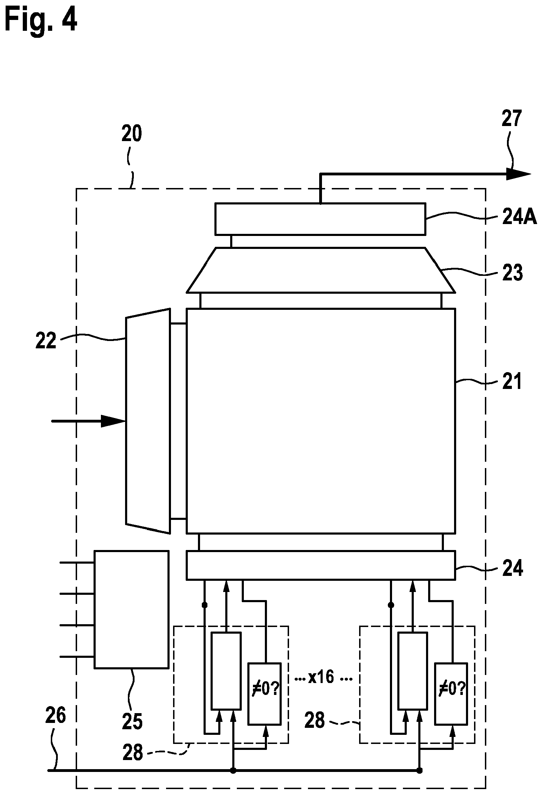

Figur 4 zeigt eine dritte Ausführungsform eines erfindungsgemäßen statischen Direktzugriffsspeicher-Blocks 20. Auch hier sind Addierer 28 in den Direktzugriffsspeicher-Block 20 integriert.

Der statische Direktzugriffsspeicher-Block 20 umfasst hier ein zweites Lese- und Schreibmodul 24A, das zwischen dem Speicherzellenfeld 21 und dem Datenausgang 27 angeordnet ist. Der Spaltendaten-Multiplexer 23 weist einen Multiplexfaktor von 1 auf, sodass alle Zellen einer Zeile des Speicherzellenfelds 21 in einem Speichertakt ausgelesen werden, und nach der Verarbeitung der Eingangsdaten das resultierende Datenwort in dieselbe Zeile zurückgeschrieben wird.

Wenn mehrere derartige statische Direktzugriffsspeicher-Blöcke 20 zusammen in einer anwendungsspezifischen integrierten Schaltung verwendet werden, können anstatt eines Aufteilens eines Datenpakets (zum Beispiel von Sensordaten) in eine Vielzahl von Eingangsdaten(-Paketen) für verschiedene statische Direktzugriffsspeicher-Blöcke 20, alle Eingangsdaten an nur einen statischen Direktzugriffsspeicher-Block 20 oder zumindest an deutliche weniger statische Direktzugriffsspeicher-Blöcke 20 gesendet werden. Der oder die aktiven statische(n) Direktzugriffsspeicher-Block/Blöcke 20 können dann in einem Speichertakt vollständig ausgelesen und überschrieben werden. Im nächsten Speichertakt können dann die zu verarbeitenden Daten an andere statische(n) Direktzugriffsspeicher-Block/Blöcke 20 gesendet werden und die statische(n) Direktzugriffsspeicher-Block/Blöcke 20, die im vorherigen Speichertakt aktiv waren, werden nicht verwendet. Auch durch diese Vorgehensweise lässt sich gegenüber dem Stand der Technik Energie einsparen.

Bei der Auswahl eines statischen Direktzugriffsspeicher-Blocks 20 zeigt sich, dass sich bei gleicher Speichergröße der verbrauchte Strom reduziert, wenn man einen kleineren Multiplexfaktor wählt. Das lässt sich dadurch erklären, dass die Datenwortzeilen in den Speicherzeilen kürzer sind und weniger Auswahltransistoren angesteuert werden müssen.

Ein erfindungsgemäßer Empfangssensor, insbesondere für ein Radar-oder Lidar-System, umfasst eine anwendungsspezifische integrierte Schaltung. Die anwendungsspezifische integrierte Schaltung umfasst mindestens einen, vorzugsweise eine Vielzahl, an statischen Direktzugriffsspeicher-Block(Blöcken) 20 nach einer der beschriebenen Ausführungsformen.

In einem solchen Empfangssensor können zum Beispiel 8 SRAM-Blöcke 20 parallel je 16 Sensordaten (Eingangsdaten) bearbeiten. Mit der Ausführungsform der Figur 4 können nun diese 8*16 Sensordaten in einem SRAM-Block 20 verarbeitet werden. Dazu wird in den SRAM-Block 20 neben dem normalen Datenpfad noch ein zweites Lese- und Schreibmodul 24A integriert, das zwischen dem Speicherzellenfeld 21 und dem Datenausgang 27 angeordnet ist. Der Spaltendaten-Multiplexer 23 weist einen Multiplexfaktor von 1 auf (der Spaltendaten-Multiplexer 23 kann hier also auch entfallen), sodass alle Zellen einer Zeile des Speicherzellenfelds 21 in einem Speichertakt ausgelesen werden, und nach der Verarbeitung der Eingangsdaten das resultierende Datenwort in dieselbe Zeile zurückgeschrieben wird. Der normale Datenpfad kann dann für die Verarbeitung optimiert werden, zum Beispiel auf eine Wortbreite von 64-bit, und um immer 8 aufkumulierte Werte auszulesen.

Dann kann pro Speichertakt zum Beispiel nur ein SRAM-Block 20 anstatt 8 SRAM-Blöcken 20 angesprochen werden. In diesem SRAM-Block 20 werden beim Verarbeiten der Sensordaten alle Speicherzellen einer Zeile bearbeitet, es werden also keine nicht benötigten Speicherzellen angesprochen. Diese Ausführungsform kann mit der Ausführungsform der Figur 3 kombiniert werden, sodass die ursprünglichen Werte, die nicht geändert werden, auch nicht ausgelesen, bearbeitet und zurückgeschrieben werden.

## Patentansprüche

1. Statischer Direktzugriffsspeicher-Block (20) insbesondere für einen Empfangssensor, umfassend
- ein Speicherzellenfeld (21),
- einen Zeilenadressen-Dekodierer (22),
- einen Spaltendaten-Multiplexer (23),
- ein Lese- und Schreibmodul (24) mit einem Leseverstärker und einem Schreib-Treiber,
- eine Steuerlogik (25),
- einen Dateneingang (26) und einen Datenausgang (27),
**dadurch gekennzeichnet, dass** der statische Direktzugriffsspeicher-Block (20) eine interne Speichertaktung aufweist, wobei in den statischen Direktzugriffsspeicher-Block (20) mindestens ein Addierer (28) zum Addieren von durch den Dateneingang (26) eingegangenen Eingangsdaten integriert ist, wobei der mindestens eine Addierer (28) zwischen dem Dateneingang (26) und dem Lese- und Schreibmodul (24) angeordnet ist, wobei der statische Direktzugriffsspeicher-Block (20) dazu eingerichtet ist, in einem Speichertakt ein ursprüngliches Datenwort aus dem Speicherzellenfeld (21) auszulesen, den mindestens einen Addierer (28) die Addition der Eingangsdaten durchführen zu lassen und dann ein resultierendes Datenwort in das Speicherzellenfeld (21) zurückzuschreiben.

2. Statischer Direktzugriffsspeicher-Block (20) nach Anspruch 1, wobei der statische Direktzugriffsspeicher-Block (20) so eingerichtet ist, dass in einem Speichertakt nur ein Vorladen einer Speicherzeile, eine Adressen-Decodierung mit Öffnen der Speicherzeile und Auswahl des ursprünglichen Datenworts und ein Schließen der Speicherzeile erfolgt.

3. Statischer Direktzugriffsspeicher-Block (20) nach Anspruch 1 oder 2, wobei der statische Direktzugriffsspeicher-Block (20) so eingerichtet ist, dass beim Zurückschreiben des resultierenden Datenworts die Speicherzeile bereits geöffnet ist und den definierten Pegel des ursprünglichen Datenworts aufweist, und wobei beim Zurückschreiben nur die Datenbits umgeladen werden, deren Inhalt sich zwischen dem ursprünglichen Datenwort und dem resultierenden Datenwort geändert hat.

4. Statischer Direktzugriffsspeicher-Block (20) nach einem der vorstehenden Ansprüche, wobei der mindestens eine Addierer so eingerichtet ist, dass er die Eingangsdaten auf Datenpakete prüft, die null sind, wobei in dem aktuellen Speichertakt nur solche Datenpakete aus dem ausgewählten ursprünglichen Datenwort im Speicherzellenfeld (21) ausgelesen werden, mit Eingangsdaten addiert werden und zurückgeschrieben werden, die solchen Datenpaketen aus den Eingangsdaten entsprechen, die ungleich null sind.

5. Statischer Direktzugriffsspeicher-Block (20) nach einem der vorstehenden Ansprüche, wobei der statische Direktzugriffsspeicher-Block (20) ein zweites Lese- und Schreibmodul (24A) umfasst, das zwischen dem Speicherzellenfeld (21) und dem Datenausgang (27) angeordnet ist, und wobei der Spaltendaten-Multiplexer (23) einen Multiplexfaktor von 1 aufweist, sodass alle Zellen einer Zeile des Speicherzellenfelds (21) in einem Speichertakt ausgelesen werden, und nach der Verarbeitung der Eingangsdaten das resultierende Datenwort in dieselbe Zeile zurückgeschrieben wird.

6. Statischer Direktzugriffsspeicher-Block (20) nach einem der vorstehenden Ansprüche, wobei der statische Direktzugriffsspeicher-Block (20) mindestens 16 Addierer (28) umfasst, wobei jeder Addierer (28) dazu eingerichtet ist, pro Speichertakt 6-Bit Daten der Eingangsdaten zu verarbeiten und diese 6-Bit Daten zu 8-Bit Daten des ursprünglichen Datenworts zu addieren.

7. Empfangssensor, insbesondere für ein Radar-oder Lidar-System, umfassend eine anwendungsspezifische integrierte Schaltung, wobei die anwendungsspezifische integrierte Schaltung mindestens einen statischen Direktzugriffsspeicher-Block (20) nach einem der vorstehenden Ansprüche umfasst.

8. Empfangssensor nach Anspruch 7, umfassend mindestens zwei statische Direktzugriffsspeicher-Blöcke (20) nach Anspruch 6, wobei in jedem Speichertakt nur ein statischer Direktzugriffsspeicher-Block (20) mit Eingangsdaten angesprochen wird.

## Claims

1. Static random access memory block (20), in particular for a receiving sensor, comprising
- a memory cell array (21),
- a row address decoder (22),
- a column data multiplexer (23),
- a reading and writing module (24) having a sense amplifier and a write driver,
- a control logic unit (25),
- a data input (26) and a data output (27),
**characterized in that** the static random access memory block (20) has internal memory clocking, wherein at least one adder (28) for adding input data received by the data input (26) is integrated in the static random access memory block (20), wherein the at least one adder (28) is arranged between the data input (26) and the reading and writing module (24), wherein the static random access memory block (20) is configured, in a memory clock cycle, to read an original data word from the memory cell array (21), to have the at least one adder (28) add the input data and to then write a resulting data word back to the memory cell array (21).

2. Static random access memory block (20) according to Claim 1, wherein the static random access memory block (20) is configured such that, in a memory clock cycle, only pre-charging of a memory row, address decoding with opening of the memory row and selection of the original data word and closing of the memory row are carried out.

3. Static random access memory block (20) according to Claim 1 or 2, wherein the static random access memory block (20) is configured in such a manner that, when writing back the resulting data word, the memory row is already open and has a defined level of the original data word, and wherein, when writing back, the charge of only those data bits whose content has changed between the original data word and the resulting data word is reversed.

4. Static random access memory block (20) according to one of the preceding claims, wherein the at least one adder is configured in such a manner that it checks the input data for data packets which are zero, wherein, in the current memory clock cycle, only those data packets which correspond to those data packets from the input data which are not equal to zero are read from the selected original data word in the memory cell array (21), are added to input data and are written back.

5. Static random access memory block (20) according to one of the preceding claims, wherein the static random access memory block (20) comprises a second reading and writing module (24A) which is arranged between the memory cell array (21) and the data output (27), and wherein the column data multiplexer (23) has a multiplex factor of 1, with the result that all cells in a row of the memory cell array (21) are read in a memory clock cycle and the resulting data word is written back to the same row after the input data have been processed.

6. Static random access memory block (20) according to one of the preceding claims, wherein the static random access memory block (20) comprises at least 16 adders (28), wherein each adder (28) is configured to process 6-bit data of the input data for each memory clock cycle and to add these 6-bit data to 8-bit data of the original data word.

7. Receiving sensor, in particular for a radar or lidar system, comprising an application-specific integrated circuit, wherein the application-specific integrated circuit comprises at least one static random access memory block (20) according to one of the preceding claims.

8. Receiving sensor according to Claim 7, comprising at least two static random access memory blocks (20) according to Claim 6, wherein input data are addressed to only one static random access memory block (20) in each memory clock cycle.

## Revendications

1. Bloc de mémoire statique à accès direct (20), destiné notamment à un capteur récepteur, ledit bloc comprenant
- une zone de cellules de mémoire (21),
- un décodeur d'adresse de ligne (22),
- un multiplexeur de données de colonne (23),
- un module de lecture et d'écriture (24) muni d'un amplificateur de lecture et d'un pilote d'écriture,
- une logique de commande (25),
- une entrée de données (26) et une sortie de données (27),
**caractérisé en ce que** le bloc de mémoire statique à accès direct (20) comporte une horloge de mémoire interne, au moins un additionneur (28) destiné à additionner des données d'entrée entrées par le biais de l'entrée de données (26) étant intégré dans le bloc de mémoire statique à accès direct (20), l'au moins un additionneur (28) étant disposé entre l'entrée de données (26) et le module de lecture et d'écriture (24), le bloc de mémoire statique à accès direct (20) étant conçu pour lire un mot de données d'origine dans la zone de cellules de mémoire (21) dans un cycle de mémoire, laisser l'au moins un additionneur (28) effectuer l'addition des données d'entrée puis réécrire un mot de données résultant dans la zone de cellules de mémoire (21).

2. Bloc de mémoire statique à accès direct (20) selon la revendication 1, le bloc de mémoire statique à accès direct (20) étant conçu de façon à effectuer dans un cycle de mémoire uniquement un pré-chargement d'une ligne de mémoire, un décodage d'adresse avec ouverture de la ligne de mémoire et sélection du mot de données d'origine et une fermeture de la ligne de mémoire prennent lieu.

3. Bloc de mémoire statique à accès direct (20) selon la revendication 1 ou 2, le bloc de mémoire statique à accès direct (20) étant conçu de telle sorte que, lorsque le mot de données résultant est réécrit, la ligne de mémoire soit déjà ouverte et comporte le niveau défini du mot de données d'origine et, lors de la réécriture, seuls soient rechargés les bits de données dont le contenu a changé entre le mot de données d'origine et le mot de données résultant.

4. Bloc de mémoire statique à accès direct (20) selon l'une des revendications précédentes, l'au moins un additionneur étant conçu de façon à vérifier les données d'entrée pour recherche des paquets de données qui sont nuls, dans le cycle de mémoire en cours seuls étant lus dans la zone de cellules de mémoire (21), ajoutés aux données d'entrée et réécrits les paquets de données provenant du mot de données d'origine sélectionné qui correspondent aux paquets de données des données d'entrée qui sont non nuls.

5. Bloc de mémoire statique à accès direct (20) selon l'une des revendications précédentes, le bloc de mémoire statique à accès direct (20) comprenant un deuxième module de lecture et d'écriture (24A) qui est disposé entre la zone de cellules de mémoire (21) et la sortie de données (27), et le multiplexeur de données de colonne (23) ayant un facteur de multiplexage de 1 de sorte que toutes les cellules d'une ligne de la zone de cellules de mémoire (21) sont lues pendant un cycle de mémoire et, après traitement des données d'entrée, le mot de données résultant étant réécrit dans la même ligne.

6. Bloc de mémoire statique à accès direct (20) selon l'une des revendications précédentes, le bloc de mémoire statique à accès direct (20) comprenant au moins 16 additionneurs (28), chaque additionneur (28) étant conçu pour traiter des données de 6 bits des données d'entrée par cycle de mémoire et pour ajouter ces données de 6 bits aux données de 8 bits du mot de données d'origine.

7. Capteur de réception, destiné notamment à un système radar ou lidar, ledit capteur de réception comprenant un circuit intégré spécifique à l'application, le circuit intégré spécifique à l'application comprenant au moins un bloc de mémoire statique à accès direct (20) selon l'une des revendications précédentes.

8. Capteur de réception selon la revendication 7, comprenant au moins deux blocs de mémoire statique à accès direct (20) selon la revendication 6, un seul bloc de mémoire statique à accès direct (20) étant soumis à des données d'entrée à chaque cycle de mémoire.
